# EUROPÄISCHE PATENTSCHRIFT

(11) **EP 1 352 456 B1**
(45) Veröffentlichungstag und Bekanntmachung des Hinweises auf die Patenterteilung: **25.06.2008**
(21) Anmeldenummer: 02704575.6
(22) Anmeldetag: 09.01.2002
(51) Int. Cl.: H02B 1/04, H05K 5/00

(54) **GEHÄUSE, INSBESONDERE FÜR DEN EINBAU ELEKTRISCHER UND ELEKTRONISCHER BAUTEILE**
ENCLOSURE, PARTICULARLY FOR ACCOMMODATING ELECTRICAL AND ELECTRONIC COMPONENTS
BOITIER, UTILISE NOTAMMENT POUR ENCASTRER DES COMPOSANTS ELECTRIQUES ET ELECTRONIQUES

(30) Priorität: 16.01.2001 DE 10101615
(43) Veröffentlichungstag der Anmeldung: 15.10.2003
(73) Patentinhaber: Rolec Gehäuse-Systeme GmbH, 31737 Rinteln (DE)
(72) Erfinder: ROSE, Friedhelm, 32457 Porta Westfalica (DE); ROSE, Matthias, 31737 Rinteln (DE)
(74) Vertreter: Seewald, Jürgen
(86) Internationale Anmeldenummer: PCT/DE2002/000066
(87) Internationale Veröffentlichungsnummer: WO 2002/056436

(56) Entgegenhaltungen:
- DE-U- 7 205 740

## Beschreibung

Die vorliegende Erfindung betrifft ein Gehäuse, insbesondere für den Einbau elektrischer und elektronischer Bauteile, bestehend aus einem Gehäuse-Unterteil und einem daran befestigbaren Deckel gemäß dem Oberbegriff des Anspruchs 1 (Siehe DE-U-7 205 740).

Handelsübliche Gehäuse, vorwiegend aus Aluminium aber auch aus glasfaserverstärktem Polyester oder aus thermoplastischem Kunststoff, haben im Gehäuse-Unterteil in den Eckbereichen jeweils eine Gewindebohrung für die Befestigung eines Deckels, der dazu mit Durchgangsbohrungen mit einer Senkung für den Schraubenkopf versehen ist. Aus Material- und Gewichtsersparnisgründen schließt sich an die Gewindebohrungen axial mit diesen fluchtend ein bis auf die Unterteil-Unterseite durchgehender Kanal an, dessen lichte Weite größer als der Durchmesser der Gewindebohrung ist. Parallel zu diesen Kanälen und in der Regel unmittelbar daneben verläuft jeweils ein Befestigungskanal. Dieser beginnt an der Unterteil-Oberseite, also in der Schließebene und mündet an seinem unteren Ende in eine Durchgangsbohrung geringeren Querschnitts, die bis zur Unterteil-Unterseite durchläuft. Durch diese Abstufung zwischen dem Befestigungskanal und der Durchgangsbohrung ist ein Auflagebund für ein Befestigungsmittel geschaffen, mit dem das Gehäuse-Unterteil an einer Unterlage befestigbar ist.

Ein derartiges Gehäuse ist aus DE 88 14 890 U1 bekannt. Es besitzt, verglichen mit der Deckelhöhe, ein relativ hohes Gehäuse-Unterteil. Als Option für einen Gehäuseanwender ist vorgesehen, daß Deckel und Gehäuse-Unterteil untereinander austauschbar sind, d.h., daß der Deckel als Gehäuse-Unterteil bzw. das Gehäuse-Unterteil als Deckel verwendet werden kann. Um dies zu gewährleisten, muß u.a. dafür gesorgt werden, daß der zum Gehäuse-Unterteil umfunktionierte Deckel ebenfalls an einer Unterlage, z.B. einer Wand oder einer Maschine, befestigbar ist. Dazu werden Befestigungskanäle, wie sie vom Gehäuse-Unterteil her bekannt sind, verwende. Bei der in dem DE 88 14 890 U1 dargestellten Ausführungsform des Gehäuses fluchten die Befestigungskanäle von Deckel und Gehäuse-Unterteil miteinander; d.h. sie gehen in der Schließebene des Gehäuses ineinander über, obwohl das funktionell nicht erforderlich ist.

Ein Nachteil dieses und anderer gattungsgemäßer Gehäuse ist darin zu sehen, daß es zum Befestigen an einer Unterlage stets geöffnet werden muß, um die Befestigungskanäle zugänglich zu machen. Das ist von Gehäuseanwendern, die ihre Elektronik in derartige Gehäuse einbauen, häufig unerwünscht, da bei der Montage der Gehäuse vor Ort die elektronischen Bauteile oder deren Leitungsverbindungen beschädigt werden können. Um dies zu vermeiden, ist es bei Aluminiumgehäusen bekannt, angeschraubte Außenbefestigungslaschen zu verwenden. Diese bedeuten einen zusätzlichen Aufwand und sind zudem optisch nicht ansprechend.

Aufgabe der vorliegenden Erfindung ist es, ein gattungsgmäßes Gehäuse zur Verfügung zu stellen, mit dem die oben genannten Nachteile des Standes der Technik vermieden werden.

Diese Aufgabe wird erfindungsgemäß durch ein Gehäuse mit den Merkmalen des Anspruchs 1 gelöst.

Überraschenderweise ist dieser Vorschlag bisher unterblieben, obwohl die erfindungsgemäße Lösung verblüffend einfach ist. Es ist dabei in Ausgestaltung der Erfindung natürlich zumindest optisch von Vorteil, wenn für die sich in die Deckeloberfläche öffnenden Befestigungskanäle eine Abdeckung vorgesehen ist. Diese kann im einfachsten Fall durch Kappen, wie sie bei dem aus dem DE 88 14 890. U1 bekannten Gehäuse zur Abdeckung der Deckelverschraubungskanäle verwendet werden, geschehen.

Vorteilhafte Weiterbildungen der Erfindung ergeben sich aus den übrigen Unteransprüchen.

Die Erfindung wird nachstehend anhand eines Ausführungsbeispiels näher erläutert. In der dazugehörigen Zeichnung zeigt:
- Fig. 1: eine Draufsicht auf ein Gehäuse bei geschlossenem Deckel mit aufgesteckten Abdeckprofilen,
- Fig. 2: einen Schnitt A-A gemäß Fig. 1, wobei nur die linke Gehäusehälfte geschnitten dargestellt ist,
- Fig. 3: eine Draufsicht auf das Gehäuse, wobei die rechte Gehäusehälfte bei abgenommenem Dekkel und die linke Gehäusehälfte bei geschlossenem Deckel, aber entferntem Abdeckprofil, dargestellt ist,
- Fig. 4: einen Schnitt B-B gemäß Fig. 3, wobei nur die linke Gehäusehälfte geschnitten dargestellt ist,
- Fig. 5: einen Schnitt C-C gemäß Fig. 1,
- Fig. 6: eine Darstellung gemäß Fig. 5 mit einer Symbolisierung der Montagefolge beim Befestigen des Gehäuses an einer Unterlage,
- Fig. 7: eine Einzelheit X gemäß Fig. 5 in vergrößertem Maßstab, und
- Fig. 8: eine Einzelheit Y gemäß Fig. 2 in vergrößertem Maßstab.

Bei dem in der Zeichnung gezeigten Gehäuse 1 handelt es sich um ein Aluminiumgehäuse mit rechteckigem Grundriß. Dieses Gehäuse 1 besteht aus einem Gehäuse-Unterteil 2, welches nach unten geschlossen und nach oben offen ist, sowie einem Deckel 3 zum Schließen des Gehäuse-Unterteils 2. In jeder der vier Ecken des Gehäuse-Unterteils 2 ist eine Gewindebohrung 4 vorgesehen, die sich nach unten in einen Kanal 5 öffnet, der bis zur Unterseite des Gehäuse-Unterteils 2 durchgeht. Diese Gewindebohrungen 4 dienen der Verschraubung des Deckels 3 mit dem Gehäuse-Unterteil 2. Dazu sind im Deckel 3 abgestufte Durchgangsbohrungen 6 vorgesehen, die einen oberen Senkbereich 6.1 für die Aufnahme des Schraubenkopfes 7.1 einer Deckelschraube 7 und einen sich daran anschließenden Bohrungsbereich 6.2 aufweisen, der bei verschraubtem Deckel 3 mit etwas radialem Spiel vom Schraubenschaft 7.2 durchsetzt wird. Wenn alle vier Deckelschrauben 7 angezogen sind, sitzt der Deckel 3 fest auf dem Gehäuse-Unterteil 2. Eine im Deckel 3 umlaufenden Nut 8 mit eingelegter Dichtung 9 und eine in die Nut 8 eingreifende, am Gehäuse-Unterteil 2 umlaufende Leiste 10 sorgen dabei für einen dichten Sitz des Deckels 3 auf dem Gehäuse-Unterteil 2.

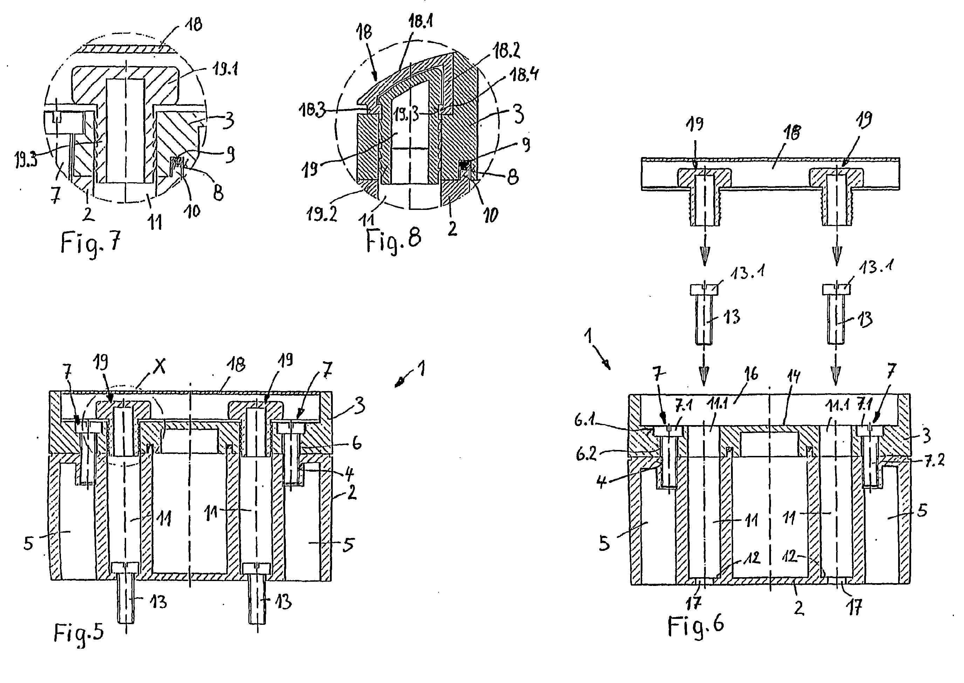

Im Bereich jeder Ecke des Gehäuse-Unterteils 2 verläuft neben dem Kanal 5 und parallel zu diesem ein Befestigungskanal 11, der an der Oberseite des Gehäuse-Unterteils 2 beginnt und in seinem Querschnitt so gewählt ist, daß eine Befestigungsschraube 13 mit ihrem Kopf 13.1 durch ihn hindurch nach unten geführt werden kann. An seinem unteren Ende mündet der Befestigungskanal 11 in eine Durchgangsbohrung 17 geringeren Durchmessers, wodurch eine Schulter 12 gebildet ist, die ein Widerlager für den Kopf 13.1 der Befestigungsschraube 13 bildet, mit der das Gehäuse-Unterteil 2 an eine Unterlage angeschraubt werden kann. Die Befestigungskanäle 11 setzen sich nach oben im Deckel 3 in Abschnitten 11.1 fort und münden dort in einer Ebene 14, die unterhalb der Deckelfläche 15 liegt und durch eine entsprechende Abstufung 16 des Deckelrandbereiches gebildet ist. Diese Ebene 14 erstreckt sich über die gesamte Deckelbreite und ist seitlich durch Fortsätze 3.1 der Seitenwandung des Deckels 3 begrenzt. Sie ist auf zwei sich gegenüberliegenden Deckelseiten identisch vorhanden. In die Ebenen 14 mündet auch der Senkbereich 6.1 der Durchgangsbohrungen 6 für die Deckelschrauben 7. Wenn der Deckel 3 auf das Gehäuse-Unterteil 2 aufgesetzt ist und die Deckelschrauben 7 angezogen sind, schließen die oberen Stirnflächen der Schraubenköpfe 7.1 bündig mit der Ebene 14 ab (Fig. 6).

Obwohl die Köpfe 7.1 der Deckelschrauben 7 bündig mit den Ebenen 14 abschließen, ist diese Lösung optisch nicht ansprechend, zumal auch die Fortsätze 11.1 der Befestigungskanäle 11 in den Ebenen 14 offenliegen. Da diese Ebenen 14 unterhalb des Niveaus der Deckelfläche 15 liegen, bietet sich die Möglichkeit an, diese Bereiche abzudecken. Dazu ist jeweils für jede Ebene 14 ein Abdeckprofil 18 aus Aluminium vorgesehen. Die Länge dieses Abdeckprofils 18 ist an den Abstand zwischen den Fortsätzen 3.1 der Seitenwände des Deckels 3 in dem Sinne angepaßt, daß es diesen Abstand mit geringem seitlichen Spiel ausfüllt. Dabei ist der Querschnitt des Abdeckprofils 18 so gestaltet, daß dieses den durch die Abstufung 16 im Deckelrandbereich entstandenen Sprung in der Deckelflächenkontur ausgleicht, indem sich seine Oberfläche 18.1 vom Niveau der Deckelfläche 15, von oben gesehen, konkav auf das Niveau der Ebene 14 absenkt. Entsprechend dieser Krümmung besitzt das Abdeckprofil 18 einen längeren Innenschenkel 18.2 und einen kürzeren Außenschenkel 18.3 (Fig. 8).

Vom Innenschenkel 18.2 und Außenschenkel 18.3 ragen kurze Leisten 18.4 senkrecht nach innen ab, die der Halterung von zwei Haltezapfen 19 aus Kunststoff am Abdeckprofil 18 dienen. Diese Haltezapfen 19 besitzen einen Kopf 19.1 sowie einen davon nach unten abragenden zylindrischen Schaft 19.2. Der Kopf 19.1 ist mit sich diametral gegenüberliegenden Nuten 19.3 versehen, die ein Einschieben der Haltezapfen 19 von der Seite her in das Abdeckprofil 18 gestatten. Dadurch sind die Haltezapfen 19 nach ihrem Einschieben in das Abdeckprofil 18 gegen Herausziehen nach unten gesichert.

Der Abstand der Haltezapfen 19 zu den Enden des Abdeckprofils 18 ist so gewählt, daß ihre Schäfte 19.2 mit den Fortsätzen 11.1 der Befestigungskanäle 11 fluchten. Des weiteren ist der Durchmesser der Schäfte 19.2 auf den Durchmesser der Fortsätze 3.1.1 so abgestimmt, daß sich die Haltezapfen 19 relativ leicht in die Fortsätze 11.1 eindrücken lassen, aber dennoch sicher in diesen gehalten sind. Um dies zu gewährleisten, sind die Schäfte 19.2 mit umlaufenden widerhakenartigen Lippen 19.4 ausgestattet, die dem Herausziehen der Haltezapfen 19 aus den Fortsätzen 11.1 einen Widerstand entgegensetzen, ein derartiges Herausziehen bei Bedarf aber dennoch ermöglichen.

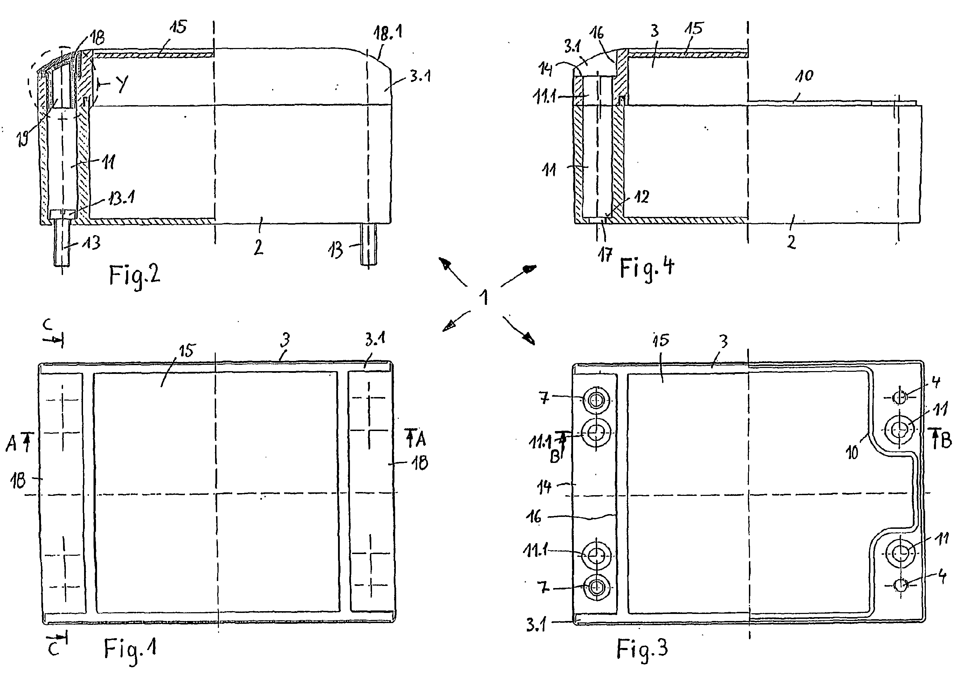

Das oben beschriebene Gehäuse 1 wird nach dem Einbau von elektrotechnischen und elektronischen Bauteilen durch Anschrauben des Deckels 3 an das Gehäuse-Unterteil 2 geschlossen. Am Anbauort ist ein Öffnen des Gehäuses 1 nicht mehr erforderlich, da die Befestigungskanäle 11 über ihre Fortsätze 11.1 im Deckel 3 zugänglich sind. Zum Anbau des Gehäuses 1 werden die Befestigungsschrauben 13 in die Befestigungskanäle 11 eingeführt und in entsprechende Gewindebohrungen der Anbauunterlage eingeschraubt. Anschließend werden die Abdeckprofile 18 durch Eindrücken ihrer Haltezapfen 19 in die Fortsätze 11.1 der Befestigungskanäle 11 montiert. Es ergibt sich dadurch eine einheitliche Deckeloberfläche, die sich aus der Deckelfläche 15 und den Oberflächen 18.1 der Abdeckprofile 18 zusammensetzt. Das Gehäuse 1 bietet dann ein aus den Fig. 1 und 2 hervorgehendes Erscheinungsbild. Wenn das Gehäuse 1 geöffnet werden bzw. von seiner Unterlage abgeschraubt werden soll, müssen zuvor die Abdeckprofile 18 entfernt werden, so daß die Deckelschrauben 7 bzw. die Schrauben 13 in den Befestigungskanälen 11 zugänglich werden.

## Patentansprüche

1. Gehäuse, insbesondere für den Einbau elektrischer und elektronischer Bauteile, bestehend aus einem Gehäuse-Unterteil (2) und einem daran durch Verschraubung befestigbaren Deckel (3), wobei zusätzlich zu den Verschraubungsstellen (4) und parallel zu diesen Befestigungskanäle (11) im Gehäuse-Unterteil (2) vorgesehen sind, durch die hindurch das Gehäuse (1) an einer Unterlage befestigbar ist, **dadurch gekennzeichnet, daß** sich die Befestigungskanäle (11, 11.1) im Deckel (3) fortsetzen und sich nach außen öffnen, so daß das Gehäuse (1) bei geschlossenem Deckel (3) an der Unterlage befestigbar ist, wobei die Befestigungskanäle (11, 11.1) in ihrem Querschnitt so gewählt sind, daß je eine Befestigungsschraube (13) mit ihrem Kopf (13.1) von oben her durch sie hindurch nach unten geführt werden kann bis zu einer Kanalverengung (17), die ein Widerlager für den Kopf (13.1) der Befestigungsschraube (13) bildet.

2. Gehäuse nach Anspruch 1, **dadurch gekennzeichnet, daß** eine Abdeckung (18) der Befestigungskanäle (11, 11.1) vorgesehen ist.

3. Gehäuse nach Anspruch 2, **dadurch gekennzeichnet, daß** sein Querschnitt rechteckig oder quadratisch ist, wobei im Bereich jeder Ecke jeweils ein Befestigungskanal (11, 11.1) sowie je eine Deckelverschraubungsstelle (7, 4) vorgesehen ist, und die Deckelverschraubungsstellen (7, 4) und die Befestigungskanäle (11, 11.1) von zwei sich gegenüberliegenden Gehäuseseiten jeweils eine gemeinsame Abdeckung (18) besitzen.

4. Gehäuse nach Anspruch 2 oder 3, **dadurch gekennzeichnet, daß** diese Abdeckung (18) im montierten Zustand bündig mit der äußeren Deckelkontur abschließt.

5. Gehäuse nach einem der Ansprüche 2 - 4, **dadurch gekennzeichnet, daß** die Abdeckung (18) durch in die Befestigungskanäle (11, 11.1) eindrückbare Rastmittel (19) am Deckel (3) festlegbar ist.

## Claims

1. Housing, in particular for the installation of electric and electronic components, consisting of a housing lower part (2) and a lid (3), which can be mounted on it by screw connection, wherein in additional to the screw connection points (4) and parallel to these, mounting channels (11), through which the housing (1) can be mounted on a support, are provided in the housing lower part (2), **characterized in that** the mounting channels (11, 11.1) continue in the lid (3) and open outwards, so that the housing (1), when the lid (3) is closed, can be mounted on the support, wherein the cross-section of the mounting channels (11, 11.1) is selected so that in each case a mounting screw (13) with its head (13.1) can be guided through it from the top downwards as far as a channel narrowing (17), which forms a counter bearing for the head (13.1) of the mounting screw (13).

2. Housing according to Claim 1, **characterized in that** a cover (18) of the mounting channels (11, 11.1) is provided.

3. Housing according to Claim 2, **characterized in that** its cross-section is rectangular or square, wherein a mounting channel (11, 11.1) as well as in each case a lid screw connection point (7, 4) is provided in the vicinity of each corner and the lid screw connection points (7, 4) and the mounting channels (11, 11.1) of two facing housing sides possess a common cover (18) in each case.

4. Housing according to Claim 2 or 3, **characterized in that** this cover (18), in the assembled state, closes flush with the outer lid contour.

5. Housing according to any one of Claims 2 to 4, **characterized in that** the cover (18) can be fixed on the lid (3) by locking means (19), which can be pressed into the mounting channels (11, 11.1).

## Revendications

1. Boîtier, destiné en particulier à l'incorporation de composants électriques et électroniques, qui comprend une partie inférieure de boîtier (2), sur laquelle un couvercle (3) peut être fixé par vissage, dans la partie inférieure du boîtier (2) étant prévus, en plus des endroits de vissage (4) et parallèlement à ceux-ci, des canaux de fixation (11), à travers lesquels le boîtier (1) peut être fixé sur un support, **caractérisé en ce que** les canaux de fixation (11, 11.1) se poursuivent dans le couvercle (3) et s'ouvrent vers l'extérieur, de manière qu'à couvercle fermé, le boîtier (1) puisse être fixé sur le support, la section transversale des canaux de fixation (11, 11.1) étant choisie de sorte qu'une vis de fixation 13 respectivement puisse y être introduite avec sa tête (13.1) jusqu'à un rétrécissement de canal (17), qui forme une butée pour la tête (13.1) de la vis de fixation (13).

2. Boîtier suivant la revendication 1, **caractérisé en ce qu'**est prévu un recouvrement (18) des canaux de fixation (11, 11.1).

3. Boîtier suivant la revendication 2, **caractérisé en ce que** sa section transversale est rectangulaire ou carrée, un canal de fixation (11, 11.1) et un endroit de vissage du couvercle (7, 4) étant respectivement prévus au niveau de chacun de ses angles, et **en ce que** les endroits de vissage du couvercle (7, 4) et les canaux de fixation (11, 11.1) possèdent respectivement un recouvrement commun (18) depuis deux côtés opposés du boîtier.

4. Boîtier suivant les revendications 2 ou 3, **caractérisé en ce qu'**en état monté, ce recouvrement (18) est à fleur avec le contour extérieur du couvercle.

5. Boîtier suivant une des revendications 2 à 4, **caractérisé en ce que** le recouvrement (18) peut être bloqué sur le couvercle (3) par des moyens de blocage encliquetables (19) pouvant être enfoncés dans les canaux de fixation 11, 11.1).
